Europäisches Patentamt

European Patent Office

Office européen des brevets

(11) Numéro de publication: **0 141 716**
**A1**

## (12) DEMANDE DE BREVET EUROPEEN

(21) Numéro de dépôt: **84402093.3**

(22) Date de dépôt: **18.10.84**

(51) Int. Cl.⁴: **H 03 K 19/007**

(30) Priorité: **26.10.83 FR 8317041**

(43) Date de publication de la demande: **15.05.85**
**Bulletin 85/20**

(84) Etats contractants désignés: **BE CH DE FR GB IT LI LU NL**

(71) Demandeur: **JEUMONT-SCHNEIDER Société anonyme dite:, 31-32, Quai de Dion Bouton, F-92811 Puteaux Cedex (FR)**

(72) Inventeur: **Gelabert, Andrès, 22, rue des Maquignons, F-95580 Margency (FR)**

(74) Mandataire: **Lejet, Christian, Société JEUMONT-SCHNEIDER 31-32, Quai de Dion Bouton, F-92811 Puteaux Cedex (FR)**

(54) Circuit logique "et" à sécurité intrinsèque.

(57) L'invention concerne un circuit logique «ET» à sécurité intrinsèque comportant une première et une seconde entrées auxquelles peuvent être appliquées des impulsions et respectivement reliées chacune à la base d'un premier et d'un deuxième transistors (1,2) au collecteur desquels est appliquée, par l'intermédiaire d'une résistance (6,7), une tension de référence (5), et comportant en outre, un troisième transistor (3) dont la base est reliée à la masse par l'intermédiaire de l'enroulement secondaire (15) d'un transformateur dont le rapport de transformation est inférieur à l'unité, le collecteur relié à la borne positive de la source de tension continue par l'intermédiaire d'une résistance (13), et à l'émetteur duquel est appliquée la tension de référence (5). Selon l'invention, le premier transistor (1) a son émetteur relié par l'intermédiaire d'une première diode (8) et son collecteur relié par l'intermédiaire d'un condensateur (9) à la masse, tandis que le deuxième transistor (2) a son émetteur directement relié et son collecteur relié par l'intermédiaire d'une branche comprenant en série un condensateur (10) et une seconde diode (11) à la masse.

L'anode de la première diode (8) et la cathode de la seconde diode (11) sont reliées à la masse.

Applications ferroviaires.

# CIRCUIT LOGIQUE "ET"
## A SECURITE INTRINSEQUE

La présente invention concerne les circuits logiques de type "ET" à sécurité intrinsèque au sens ferroviaire de ce terme, c'est-à-dire tels qu'aucune anomalie de fonctionnement, quelle qu'elle soit, ne puisse entraîner la transmission d'une information moins restrictive que celle autorisée par les conditions présentes à l'entrée du circuit.

De telles portes sont généralement mises en oeuvre dans les circuits de commande ou de contrôle des chemins de fer, notamment pour la signalisation et pour le pilotage automatique des trains.

Le brevet français FR-A 2 147 481 décrit par exemple un tel circuit logique "ET". Selon ce brevet, le circuit logique "ET" comporte :

- deux entrées soumises respectivement à une impulsion positive et reliées chacune à la base d'un transistor NPN dont l'émetteur est relié à la masse et dont le collecteur est relié à la première borne primaire d'un transformateur monophasé, la seconde borne primaire de chacun des deux transformateurs précités étant connectée d'une part à l'émetteur d'un troisième transistor NPN, d'autre part à la borne intermédiaire d'un pont diviseur à résistances branché entre la masse et le pôle positif d'une source à courant continu, les secondaires des deux transformateurs étant montés en série entre la masse et la base du troisième transistor dont le collecteur est relié au pôle positif de la source par l'intermédiaire d'une résistance,

- un quatrième transistor PNP, dont la base est reliée par l'intermédiaire d'une résistance au collecteur du troisième transistor, dont l'émetteur est relié au pôle positif de la source et dont le collecteur est relié à la masse par l'intermédiaire d'une résistance dont les bornes constituent la sortie du circuit logique, la masse étant connectée au pôle négatif de la source. Malgré son bon fonctionnement, un tel circuit présente notamment l'inconvénient de mettre en oeuvre deux transformateurs dont on connaît les problèmes liés à leur coût et à leur encombrement.

La présente invention a pour objet un circuit logique similaire mais n'incluant qu'un seul transformateur.

Le circuit logique "ET" à sécurité intrinsèque selon l'invention, comporte une première et une seconde entrées auxquelles peuvent être appliquées des impulsions et respectivement reliées chacune à la base d'un premier et d'un deuxième transistors au collecteur desquels est appliquée, par l'intermédiaire d'une résistance, une tension de référence ; il comporte, en outre, un troisième transistor dont la base est reliée à la première borne d'une source de tension continue par l'intermédiaire de l'enroulement secondaire d'un transformateur dont le rapport de transformation est inférieur à l'unité, le collecteur relié à la seconde borne de ladite source de tension continue par l'intermédiaire d'une résistance et à l'émetteur duquel est appliqué la tension de référence.

Le premier transistor a son émetteur relié par l'intermédiaire d'une première diode et son collecteur relié par l'intermédiaire d'un condensateur à la première borne de la source de tension continue, tandis que le deuxième transistor a son émetteur directement relié et son collecteur relié par l'intermédiaire d'une branche comprenant en série un condensateur et une seconde diode à la première borne de la source de tension continue.

Le point de jonction du condensateur et de la seconde diode est relié au point de jonction de l'émetteur du premier transistor et de la première diode par l'intermédiaire de l'enroulement primaire du tranformateur.

Selon un mode préféré de réalisation, la première borne qui constitue le pôle négatif de la source de tension est connectée à la masse et les transistors sont du type NPN. L'anode de la première diode et la cathode de la seconde diode sont reliées à la masse.

L'invention sera mieux comprise et d'autres buts, avantages et caractéristiques de celle-ci apparaîtront plus clairement à la lecture de la description qui suit d'un mode de réalisation donné à titre non limitatif, et à laquelle une planche de dessin est annexée.

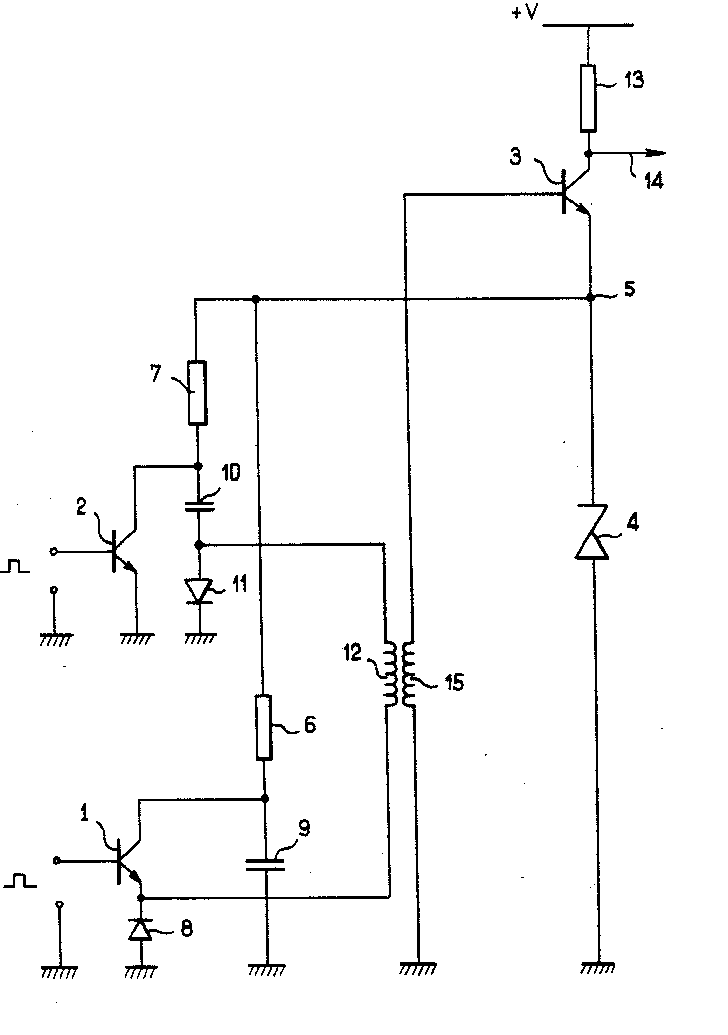

La figure unique représente le schéma électrique d'un circuit logique "ET" conforme à la présente invention.

En référence maintenant à cette figure, le circuit logique "ET" comprend trois transistors du type NPN, respectivement 1, 2, 3.

La base des deux premiers transistors 1, 2 constitue les deux entrées du circuit auxquelles sont appliquées des impulsions positives. Une diode Zener 4 détermine au point 5 une tension de référence comprise entre la masse et la tension continue positive délivrée par la source de tension. Les deux transistors d'entrée 1, 2 sont polarisés au moyen de cette tension de référence, c'est-à-dire que leur collecteur respectif est relié au point 5 par l'intermédiaire d'une résistance 6, 7. Comme on peut le constater sur la figure, l'émetteur du premier transistor 1 est relié à la masse par l'intermédiaire d'une diode 8 dont l'anode est reliée à la masse, tandis que l'émetteur du deuxième transistor 2 est relié directement à la masse.

En outre, le collecteur du premier transistor 1 est relié à la masse par l'intermédiaire d'un condensateur 9, tandis que celui du deuxième transistor 2 est relié à la masse par l'intermédiaire d'une branche comprenant en série un condensateur 10 et une diode 11 dont la cathode est reliée à la masse.

Le collecteur du deuxième transistor 2 est relié à l'émetteur du premier transistor 1 par l'intermédiaire du condensateur 10 et de l'enroulement primaire 12 d'un transformateur dont le rapport de transformation est inférieur à l'unité, par exemple est égal à 1 : 0,6.

Le troisième transistor 3 a son émetteur relié au point 5 et son collecteur, qui constitue la sortie 14 du circuit logique, relié à la borne positive de la source de tension par l'intermédiaire d'une résistance 13 de polarisation. Sa base est reliée à la masse par l'intermédiaire de l'enroulement secondaire 15 du transformateur.

Le fonctionnement de ce circuit logique "ET" est le suivant, en supposant qu'à l'instant initial les deux condensateurs 9 et 10 sont chargés. Lorsque l'on applique sur la base du transistor 2 une impulsion positive, ce transistor 2 se sature et la borne positive du condensateur chargé 10 est mise à la masse. Ce condensateur 10 se décharge alors dans le circuit comprenant l'enroulement primaire 12 du transformateur et la diode 8.

Si l'on applique sur la base du transistor 1 une impulsion positive, ce transistor se sature et devient passant. Le condensateur 9 se décharge alors dans le circuit comprenant la jonction collecteur-émetteur de ce transistor 1, l'enroulement primaire 12 du transformateur et la diode 11. Le rapport de transformation du transformateur ayant été judicieusement choisi de telle manière que le courant de décharge de l'un ou l'autre condensateur 9, 10 ne puisse induire dans son enroulement secondaire 15 une tension permettant de saturer le troisième transistor 3, ce dernier reste bloqué et une tension positive est maintenue sur la sortie 14 du circuit. Ce rapport est également choisi de telle manière que la somme des deux courants de décharge induise, dans l'enroulement secondaire 15, une tension suffisante pour saturer le troisième transistor 3.

De ce fait, lorsque les deux condensateurs 9, 10 se déchargent en même temps, suite à l'application simultanée ou quasi-simultanée d'une impulsion positive sur la base de chacun des deux transistors 1, 2, le transistor 3 devient passant et la tension de référence déterminée par la diode Zener 4 au point 5 apparaît sur la sortie 14 du circuit.

L'Homme de l'Art connectera favorablement la sortie 14 à un autre transistor de manière à obtenir le signal souhaité à la sortie du dispositif.

On constate aisément en outre que ce circuit logique est à sécurité intrinsèque puisque de la défaillance de l'un quelconque de ses éléments résulte la non-modification du signal délivré à la sortie 14 du circuit, et ceci, quelque soit le type de défaillance des transistors 1, 2, des diodes 8, 11, des condensateurs 9, 10 ou des enroulements 12, 15 du transformateur.

Bien évidemment, toute modification apportée par l'Homme de l'Art dans le même esprit ne sortirait pas du cadre de la présente invention.

6

REVENDICATIONS

1 - Circuit logique "ET" à sécurité intrinsèque comportant une première et une seconde entrées auxquelles peuvent être appliquées des impulsions, et respectivement reliées chacune à la base d'un premier et d'un deuxième transistors (1, 2) au collecteur desquels est appliquée, par l'intermédiaire d'une résistance (6, 7), une tension de référence (5) et comportant, en outre, un troisième transistor (3) dont la base est reliée à la première borne d'une source de tension continue par l'intermédiaire de l'enroulement secondaire (15) d'un transformateur dont le rapport de transformation est inférieur à l'unité, le collecteur relié à la seconde borne de ladite source de tension continue par l'intermédiaire d'une résistance (13), et à l'émetteur duquel est appliquée ladite tension de référence (5), caractérisé en ce que ledit premier transistor (1) a son émetteur relié par l'intermédiaire d'une première diode (8) et son collecteur relié par l'intermédiaire d'un condensateur (9), à ladite première borne, que ledit deuxième transistor (2) a son émetteur directement relié et son collecteur relié par l'intermédiaire d'une branche comprenant en série un condensateur (10) et une seconde diode (11), à ladite première borne, et que le point de jonction du condensateur (10) et de ladite seconde diode (11) est relié au point de jonction de l'émetteur dudit premier transistor (1) et de ladite première diode (8) par l'intermédiaire de l'enroulement primaire (12) dudit transformateur.

2 - Circuit logique selon la première revendication caractérisé en ce que ladite première borne qui constitue le pôle négatif de ladite source est connectée à la masse, lesdits transistors étant du type NPN, l'anode de ladite première diode (8) et la cathode de ladite seconde diode (11) étant reliées à la masse.

0141716

Office européen
des brevets

**RAPPORT DE RECHERCHE EUROPEENNE**

0141716

Numéro de la demande

EP 84 40 2093

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | ELEKTRIE, vol. 22, no. 1, janvier 1968, pages 15-18, Berlin, DE; H. SCHULZE: "Wege zu fehlersicheren elektronischen Steuerungssystemen mit binärer Wirkung" <br> * Figure 9; page 18, colonne de gauche, lignes 12-17 * | 1 | H 03 K 19/007 |
| D,A | FR-A-2 147 481 (JEUMONT-SCHNEIDER) | 1 | |
| A | FR-A-2 006 005 (LICENTIA) | 1 | |

**DOMAINES TECHNIQUES RECHERCHES (Int. Cl.4)**

H 03 K

Le présent rapport de recherche a été établi pour toutes les revendications

| Lieu de la recherche | Date d'achèvement de la recherche | Examinateur |
|---|---|---|
| LA HAYE | 01-02-1985 | FEUER F.S. |